Europäisches Patentamt

European Patent Office

Office européen des brevets

(19)

(11) Publication number: **0 226 208 B1**

## (12) EUROPEAN PATENT SPECIFICATION

(45) Date of publication of patent specification: **21.11.91**   (51) Int. Cl.⁵: **H01L 21/312, H01L 23/28**

(21) Application number: **86117503.2**

(22) Date of filing: **16.12.86**

(54) **Insulating film for semiconductor, production of the same and liquid composition for producing the same.**

(30) Priority: **17.12.85 JP 285060/85**

(43) Date of publication of application:
**24.06.87 Bulletin 87/26**

(45) Publication of the grant of the patent:
**21.11.91 Bulletin 91/47**

(84) Designated Contracting States:
**BE DE FR GB IT NL**

(56) References cited:
**EP-A- 0 021 818**
**EP-A- 0 076 656**

(73) Proprietor: **SUMITOMO CHEMICAL COMPANY, LIMITED**
**Kitahama 4-chome 5-33**
**Chuo-ku Osaka 541(JP)**

(72) Inventor: **Niwa, Kenji**
**6-4-16, Maebarahigashi**
**Funabashi-shi Chiba-ken(JP)**
Inventor: **Sawaguri, Yasuyoshi**
**1-9, Yushudainishi**
**Ichihara-shi Chiba-ken(JP)**
Inventor: **Oh-ya, Asao**
**1-9, Yushudainishi**
**Ichihara-shi Chiba-ken(JP)**
Inventor: **Koike, Hironobu**
**1-9, Yushudainishi**
**Ichihara-shi Chiba-ken(JP)**
Inventor: **Suzuki, Yutaka**
**135, Iriyamazu**
**Ichihara-shi Chiba-ken(JP)**
Inventor: **Inoue, Haruo**
**832-4, Shiizu**
**Ichihara-shi Chiba-ken(JP)**

(74) Representative: **Vossius & Partner**
**Siebertstrasse 4 P.O. Box 86 07 67**
**W-8000 München 86(DE)**

**Description**

The present invention relates to an insulating film for a semiconductor, a method for producing said film and a liquid composition for use in producing said film. More particularly, it relates to a liquid composition comprising a siloxane prepolymer and an organic solvent for use in the production of an insulating film for a semiconductor, a method for producing an insulating film for a semiconductor from said composition, and an insulating film for a semiconductor produced from said composition.

Insulating films for semiconductors are widely used not only for insulation between polysilicone and an aluminum wiring layer or between aluminum wiring layers but also for protecting PN junctions or the surface of the device.

Conventionally, the insulating film is formed by chemical vapor deposition (CVD) or by film coating. CVD is widely used to deposit $SiO_2$ or $Si_3N_4$ because of its high reliability, while the film coating is only employed for forming a protective film.

However, as the degree of integration of the semiconductor increases, the gaps or grooves between the lines in the pattern become narrower and narrower and the unevenness of the surface of the device becomes larger and larger. Therefore, it is difficult to produce insulating films having satisfactory insulating quality by CVD, since the quality of the film formed by CVD largely depends on the surface structure. In view of the above circumstances, film coating has been reevaluated because it can form insulating films having good surface evenness.

Many materials have been proposed to be used in the production of insulating films by film coating.

Typical examples of organic materials are polyimide and polyimide silicone. Although these polymers have good surface evenness and crack resistance, they are poor in heat resistance and adhesion with a substrate made of silicon, aluminum, $SiO_2$, $Si_3N_4$ and the like, so that their insulating property may tend to be deteriorated after extended use of the semiconductor. Disadvantageously, they are partially decomposed at 450°C or higher.

Although a film coating of silica glass such as a polycondensation product of tetraethoxysilane has good heat resistance and adhesion with the substrate, it has poor crack resistance so that it cannot produce a film with a thickness of 6,000 Å or more (10Å = 1nm). In addition, this film cannot completely fill grooves of 1 μm in width and 1 μm in depth.

Polyladder organosiloxane or a composite of polyladder organosiloxane and silica glass are proposed as the insulating films but they do not have sufficient adhesion with the substrate, crack resistance or film surface evenness so that they cannot be practically used (cf. Japanese Patent Kokai Publication (unexamined) Nos. 83563/1982, 131250/1982 and 129261/1981).

Polydihydrogen siloxane proposed by Japanese Patent Kokai Publication (unexamined) No. 86018/1985 should be baked at 450°C for one hour in an atmosphere of oxygen and its weight increases by about 10 %. In addition, it suffers from an increase of its volume in baking, the influence of which on the characteristics of the device cannot be ignored. When the thickness of the film is increased, only an insufficient amount of oxygen diffuses into the film, so that it is difficult to produce a homogeneous insulating film.

One object of the present invention is to provide an insulating film for a semiconductor which is stable at a temperature of at least 500°C.

Another object of the present invention is to provide an insulating film for a semiconductor which can fill grooves in a micro pattern on the semiconductor.

A further object of the present invention is to provide an insulating film for semiconductors which has good crack resistance, adhesivity with a substrate and surface evenness.

These objects of the present invention are accomplished by the insulating film for a semiconductor of the invention, which comprises siloxane polymer.

According to the film coating method, the insulating film is formed on the semiconductor by dissolving a base polymer in an organic solvent, applying the solution of the polymer to a substrate by dip coating or spin coating, heating the substrate applied with the solution to thermally polycondensate the polymer and to remove the organic solvent so as to form a glassy film or a macromolecular polymer film.

When the base polymer is tetraethoxysilane or polyladder organosiloxane, the solution starts to solidify in the spin coating stage in which a part of the organic solvent is about to evaporate, so that the film is cured before the grooves of the micro pattern are sufficiently filled. In view of such drawbacks, the inventors had an idea to add a bifunctional compound such as dimethylsiloxane and diphenylsiloxane to the conventional insulating film forming polymer and found that such mixture would not solidify even after the evaporation of the solvent. Further, it was found that the addition of a tetrafunctional compound such as tetraethoxysilane would improve adhesivity of the film formed with the substrate.

It is known that a thicker film has better surface evenness. For example, for producing an insulating film having good evenness on an aluminum wiring pattern having a level difference of 1 $\mu$m (10,000 Å), it is essential that the insulating film has a thickness of at least 12,000 Å on the concave parts and at least 2,000 Å on the convex parts and is crack free after formation of the film. Thus, the insulating film with a thickness of at least 12,000 Å should be crack free on a wafer having a flat surface.

As a result of the extensive study to find an insulating film for a semiconductor which satisfies the above requirements, it has been found that an insulating film produced from a polymer comprising tetrafunctional, trifunctional and bifunctional siloxanes in a certain specific ratio does not crack even when it has a thickness larger than 12,000 Å, it is tough and further it is stable at 500°C. The present invention has been completed based on this finding.

Accordingly, the present invention relates to a siloxane polymer having the inorganic properties of the tetrafunctional siloxane, the solubility in an organic solvent and the vitrification property of the trifunctional siloxane and solubility in an organic solvent and the softening effect of the bifunctional siloxane, which polymer is suitable for producing the insulating film for the semiconductor.

According to one aspect of the present invention, there is provided an insulating film for a semiconductor which comprises a cured product of a siloxane prepolymer produced by hydrolyzing and polycondensating

(a) a tetraalkoxysilane of the formula:

$$Si(OR^1)4 \qquad (I)$$

and (b) an alkyl- or aryl-trialkoxysilane of the formula:

$$R^2Si(OR^3)_3 \qquad (II)$$

and (c) an dialkyl- or diaryl-dialkoxysilane of the formula:

$$R^4R^5Si(OR^6)_2 \qquad (III)$$

in a molar fraction of (a):(b):(c) of 0.14-0.50 : 0.03-0.66 : 0.11-0.66,
wherein $R^1$ to $R^6$ are the same or different and are alkyl groups having 1 to 6 carbon atoms or aryl groups having 6 to 10 carbon atoms.

According to another aspect of the present invention, there is provided a method for producing an insulating film on a semiconductor which comprises applying a mixture of the above siloxane prepolymer in an organic solvent on the surface of the semiconductor and thermally treating it at temperature of 400°C or higher in the presence of oxygen.

According to further aspect of the present invention, there is provided a liquid composition for use in forming an insulating film for a semiconductor which comprises the above siloxane prepolymer and and organic solvent.

In the present invention, the tetraalkylsilane (I) is a tetrafunctional component, the alkyl- or aryl-trialkoxysilane (II) (hereinafter referred to as "trialkoxysilane") is a trifunctional component and the dialkyl- or diaryl-dialkoxysilane (III) (hereinafter referred to as "dialkoxysilane") is a bifunctional component.

Each of $R^1$ to $R^6$ stands for an alkyl or aryl group. Among them, $R^2$, $R^4$ and $R^5$ are preferably methyl groups, ethyl groups or phenyl groups and more preferably methyl groups or phenyl groups. They may be the same or different. Each of $R^1$, $R^3$ and $R^6$ is preferably a $C_1$ to $C_4$ alkyl or a phenyl group and more preferably a methyl group or an ethyl group due to the high reaction rate. They may be also the same or different.

Specific examples of the tetraalkoxysilane (I) are tetramethoxysilane, tetraethoxysilane, tetraisopropoxysilane, tetraphenoxysilane and the like. Among them, tetramethoxysilane and tetraethoxysilane are preferred.

Specific examples of the trialkoxysilane (II) are methyltrimethoxysilane, methyltriethoxysilane, methyltriisopropoxysilane, methyltriphenoxysilane, ethyltrimethoxysilane, ethyltriethoxysilane, ethyltriisopropoxysilane, ethyltriphenoxysilane, phenyltrimethoxysilane, phenyltriethoxysilane, phenyltriisopropoxysilane, phenyltriphenoxysilane and the like. Among them, methyltrimethoxysilane, methyltriphenoxysilane and methyltriethoxysilane are preferred.

Specific examples of the dialkoxysilane (III) are dimethyldimethoxysilane, dimethyldiethoxysilane, dimethyldiisopropoxysilane, dimethyldiphenoxysilane, diethyldimethoxysilane, diethyldiethoxysilane, diethyldiisopropoxysilane, diethyldiphenoxysilane, diisopropyldimethoxysilane, diisopropyldiethoxysilane, diisopropyldiisopropoxysilane, diisopropyldiphenoxysilane, diphenyldimethoxysilane, diphenyldiethoxysilane, diphenyldiisopropoxysilane, diphenyldiphenoxysilane and the like. Among them, dimethyldimethoxysilane, dimethyldiethoxysilane and diphenyldiethoxysilane are preferred.

The molar fraction of the tetraalkoxysilane (I), the trialkoxysilane (II) and the dialkoxysilane (III) is 0.14-0.50 : 0.03-0.66 : 0.11-0.66 and preferably 0.25-0.42 : 0.29-0.38 : 0.29-0.38.

When the content of the tetrafunctional component in the siloxane prepolymer composition increases, the applied film is hard and tends to crack during the formation of the insulating film by heating or subsequent cooling of the film. Thus, its molar fraction is preferably from 0.14 to 0.50. When the content of the trifunctional component is too small the film tends to crack. When it is too large, the adhesivity of the film with the substrate is deteriorated. Thus, its molar fraction is preferably from 0.03 to 0.66. When the content of the bifunctional component is small, the film loses crack resistance and ability for filling the micro-grooves although the adhesivity of the film with the substrate is improved. When it is too large, the film greatly shrinks and has poor surface evenness and adhesivity with the substrate. Thus, its molar fraction is from 0.11 to 0.66.

It is assumed that since the presence of the bifunctional component could induce scission of the polymer chain, namely depolymerization in the step of forming the insulating film by heat treatment, strain would not remain in the resulting film so that the crack free film could be improved.

If the bifunctional siloxane prepolymer is mixed with one of other functional prepolymers such as polydimethylsiloxane, a part of the bifunctional siloxane prepolymer is decomposed and vaporized during the formation of the film by the heat treatment and a part of it is depolymerized and polycondensated with other polymer chains. However, the polydimethylsiloxane accumulates near the surface of the film and is polymerized so that not only the adhesivity of the film with the substrate is deteriorated but also the surface evenness of the film is decreased.

The weight-average molecular weight of the siloxane prepolymer as determined by the GPC method (converted to the molecular weight of polystyrene)is from 2,000 to 50,000, preferably from 3,000 to 30,000.

When the weight-average molecular weight is less than 2,000,the film forming property is deteriorated and the residual amount of the polymer in the film is decreased. When the molecular weight is larger than 50,000,the viscosity of the solution of the polymer is unpractically high.

The dispersity Q of the prepolymer is preferably not more than 20, more preferably not more than 5, and most preferably not more than 3. When the dispersity is more than 20, an insulating film having a smooth surface is not produced.

Now, the preparation of the siloxane prepolymer will be explained.

Polycondensation of alkoxysilane is carried out in the presence of an acid catalyst or an alkali catalyst and water. Specific examples of the acid catalyst are hydrochloric acid, nitric acid, sulfuric acid, acetic acid and the like. Specific examples of the alkali catalyst are sodium hydroxide, potassium hydroxide, ammonia, tetramethylammonium hydroxide, pyridine and the like. Although any of these catalysts may be used for polycondensation of the siloxane prepolymer according to the present invention, preferably used are hydrochloric acid, acetic acid and ammonia due to easy post purification, since the insulating film is coated on the semiconductor so that it should be highly pure. The reaction temperature is not higher than 150°C, and preferably from 0 to 100°C.

Usually, the tetraalkoxysilane, trialkoxysilane and the dialkoxysilane are simultaneously polymerized, although the the components are added to the polymerization system in an arbitrary order. More preferably, the dialkoxysilane is firstly polycondensated and then the tetraalkoxysilane and the trialkoxysilane are polycondensated. Namely, the dialkoxysilane is polymerized to form oligomers comprising di- to deca-mers, preferably tri- to nona-mers, and then the tetraalkoxysilane and trialkoxysilane are copolymerized with the oligomer so as to introduce blocks of the dialkylsilane in the polymer chain. Thereby, the crack resistance of the insulating film is so increased that an insulating film having a thickness of 1.5 $\mu$m or more does not crack.

The prepolymerization of the siloxane can be carried out batchwise or continuously in the presence or absence of a solvent. Examples of the solvent are alcohols (e.g., methanol, ethanol, isopropanol, etc.), ketones (e.g., methyl ethyl ketone, methyl isobutyl ketone, etc.) and aromatic compounds (e.g., benzene, toluene, etc.). The solvent used in the prepolymerization may form a part or whole of the solvent contained in the insulating film forming composition of the present invention.

The catalyst may be added to the polymerization system before water is added or added dropwise together with water.

Alternatively, the dialkoxysilane is polycondensated in the presence of the catalyst and water and then the tetraalkoxysilane, the trialkoxysilane and water are added dropwise.

Water is used in an amount 0.9 to 1.2 times of the stoichiometric amount (one molecule of water per

4

two alkoxy groups). When the amount of water is too large, the polymer is gelled to form a material insoluble in the organic solvent. When the amount of water is too small, too many unreacted alkoxyl groups undesirably remain.

As understood from the above explanation, since the polymer produced according to the present invention comprises block or random copolymer of the tetra-, tri- and bifunctional components, the insulating film comprising said polymer has superior properties compared with the conventional insulating films.

Then, the liquid composition for use in forming the insulating film for semiconductors according to the present invention will be explained.

The siloxane prepolymer as produced by the method described above is used in the form of a solution in an organic solvent in a suitable concentration. Examples of the solvent are alcohols (e.g., methanol, ethanol, isopropanol, etc.), ketones (e.g., acetone, methyl ethyl ketone, methyl isobutyl ketone, etc.), monoalkyl ethers of ethylene glycol (e.g., butyl cellosolve, etc.), monoalkyl ethers of propylene glycol (e.g., 1-methoxy-2-propanol, etc.) and aromatic compounds (e.g., benzene, toluene, etc.) as well as mixtures thereof.

The concentration of the siloxane prepolymer varies with the application conditions and is usually at least 4 % by weight and preferably at least 10 % by weight.

The insulating film may be formed on the semiconductor as follows:

The insulating film forming composition is applied on the surface of the semiconductor by spin coating or dip coating. After thoroughly evaporating the solvent by air drying or low temperature heating, the composition on the semiconductor is heated in the presence of oxygen at temperature not lower than 400° C for at least 10 minutes, preferably at least 30 minutes to decompose the unreacted alkoxy groups so as to form siloxane bondings.

Preferred embodiments of the present invention are shown in the following examples, wherein the physicochemical properties of the polymer are measured as follows:

Weight Average Molecular Weight (Mw)

The value measured by gel permeation chromatography (GPC) is converted to the molecular weight obtained for polystyrene (standard beads) (SL-105 of Shodex Standard, S series manufactured by Showa Denko).

GPC measurement is carried out by means of TRIROTAR-III (manufactured by Nippon Bunko) with the use of, as column, Shodex A-80M (8mm x 500 mm) and/or KF-802 (8 mm x 300 mm) (both manufactured by Showa Denko), as detector, RI and as eluent, ethyl acetate. The flow rate is 1 ml/min.

Dispersity

Dispersity Q is calculated according to the equation by a usual method:

$Q = Mw/Mn$.

Mw: Weight average molecular weight.

Mn: Number average molecular weight.

Thickness of Coated Film

The thickness of the coated film is measured by means of Talistep manufactured by Ranktailor Hobson.

In the Examples, the insulating film forming composition was applied on the semiconductor by spin coating by means of Mikasa Spinner 1H-360 (manufacture by Mikasa) in which several mililiters of the composition are dropped on the surface of the semiconductor and it is spun at 500 to 3,500 rpm for 15 seconds.

Example 1

Into a one liter flask equipped with stirrer, were charged dimethyldiethoxysilane (DMDES) (157 g), methyltriethoxysilane (MTES) (157 g), tetraethoxysilane (TEOS) (220 g) and isopropanol (160 g). Then, a mixture of 0.1 N-HCl (10.6 g) and pure water (98 g) was added at once. The initial temperature was 25° C. As the reaction proceeded, the temperature rose to 50° C. Within 20 minutes from the initiation of the reaction, the reaction mixture was heated to 80° C and then refluxed for one hour to form a prepolymer having Mw of 7,500 and dispersity Q of 1.36.

A 40 % solution of the siloxane prepolymer in isopropanol was spin coated on a silicon wafer having no pattern. The coated wafer was heated in a diffusion furnace having an atmosphere comprising nitrogen and oxygen in a volume ratio of 80:20 at 100°C for 10 minutes and baked at 450°C for 30 minutes to form an insulating film on the wafer. The film had a thickness of 14,000 Å. Observation of the film surface by a microscope (magnification of 80 times) revealed that no cracks had developed on the film surface.

The film on the wafer was reheated at 450°C for 30 minutes. The thickness of the film remained unchanged and was 14,000 Å and no cracks had developed on the surface.

The film on the wafer was further heated to 500°C for 30 minutes. The thickness of the film was 13,900 Å and hence there was no substantial change in the film thickness before and after heating.

The 40 % solution of the siloxane prepolymer in isopropanol was diluted with isopropanol to 1.3 time volume and spin coated at 3,500 rpm on a 10 cm (4 inch) wafer having an aluminum pattern with 1 μm level difference. The wafer was heated to 100°C for 10 minutes and baked at 450°C for 30 minutes. The thickness of the film was 2,000 Å on the aluminum wiring and 11,800 Å on the grooves.

The wafer on which the insulating film was formed was cut and the filling degree of the grooves and the surface evenness were observed by a scanning electron microscope (magnification of 10,000 times) to find that they were good. No cracks had developed on the film surface.

### Example 2

Into a 500 ml round flask equipped with a stirrer, DMDES (60 g), MTES (71 g) and TEOS (42 g) were charged. Then, a mixture of isopropanol (30 g), 0.1 N-HCl (4 g) and pure water (32 g) was dropwise added at room temperature over 30 minutes at a constant rate. Thereafter, the temperature was raised to 80°C over 10 minutes and refluxed for one hour. The reaction mixture contained 35 % by weight of a siloxane prepolymer having Mw of 6,100 and dispersity Q of 1.4.

In the same manner as in Example 1, the above prepolymer solution was coated on the wafer having no pattern and the wafer having the aluminum wiring. The insulating film up to a thickness of 14,000 Å did not developed any crack but the film having a thickness of 16,000 Å developed cracks all over the surface. The filling degree of the grooves and the surface evenness were satisfactory.

### Example 3

Into a 500 ml round flask equipped with a stirrer, DMDES (105 g), isopropanol (40 g) and concentrate hydrochloric acid (42 g) were charged and pure water (10 g) was dropwise added at room temperature over about one minute followed by 30 minutes stirring. After evaporating isopropanol and resulting ethanol under reduced pressure, MTES (100 g), TEOS (150 g) and 30 % hydrochloric acid (0.1 ml) were added and stirred for 10 minutes. Then, pure water (44 g) was dropwise added over about 2 hours to proceed polycondensation with keeping the reaction temperature not higher than 35°C by cooling the flask with ice. After 10 minutes from the completion of the addition of water, resulting ethanol was removed and then isopropanol (180 g) was added to obtain a siloxane prepolymer having Mw of 54,000 and Q of 3.0.

Toluene (180 g) was added to the prepolymer to prepare an insulating film forming solution containing 33% by weight of the prepolymer and the solution was filtered to remove particles such as gel through a membrane filter of 0.2 μm pore. The solution was coated on a wafer with varying the revolution rate of the spinner and heated and baked in the same manner as in Example 1. The microscopic observation of the surface of the formed film with magnification of 80 times revealed that no cracks had developed at a film thickness of 18,000 Å or less although a few cracks had developed at a film thickness of 20,000 Å. The wafer coated with the insulting film of 18,000 Å in thickness was reheated at 500°C for 30 minutes and the film thickness was substantially unchanged.

### Example 4

To evaluate adhesivity of the insulating film of the present invention, each of the solutions of the prepolymers prepared in Examples 1, 2 and 3 were spin coated at 3,500 rpm on a silicon wafer, a silicon wafer metallized with aluminum, a silicon wafer on which an $SiO_2$ layer was formed by CVD and a silicon wafer on which an $Si_3N_4$ layer was formed by CVD. Then, each wafer was heated in a diffusion surface at 100°C for 10 minutes and baked at 450°C for 30 minutes to form an insulating film.

The film surface was cut with a knife to mark 5 mm squares. An adhesive tape (Celotape. Trade mark of Nichiban) was adhered on the cut surface and peeled off quickly. No part of the cut film was peeled off.

Examples 5 and 6

In the same manner as in Example 1 but using an equimolar amount of diphenyldiethoxysilane (DPDES) in place of (DMDES) (Example 5) or using an equimolar amount of phenyltriethoxysilane (PTES) in place of MTES, an insulating film forming composition was prepared and an insulating film was formed on a wafer.

Crack resistance after reheating at 450°C was evaluated in terms of the maximum film thickness at which no crack was developed. The results are shown in Table 1.

Table 1

| Example No. | Alkoxysilane | | | Crack free max. film thickness (A) |
|---|---|---|---|---|
| | Bifunctional | Trifunctional | Tetrafunctional | |
| 1 | DMDES | MTES | TEOS | 14,000 |
| 5 | DPDES | MTES | TEOS | 13,500 |
| 6 | DMDES | PTES | TEOS | 14,500 |

Examples 7-10 and Comparative Examples 1-8

In the same manner as in Example 3 but varying the amount of DMDES, MTES or TEOS and heating the coated composition at 130°C for 10 minutes and baking it at 450°C for 30 minutes, an insulating film was formed on the wafer and its crack resistance was evaluated. The results are shown in Table 2.

Table 2

| Example No. | Alkoxysilane (Molar fraction) | | | Molecular weight of prepolymer (Mw) | Crack free max. film thickness (A) |
|---|---|---|---|---|---|
| | DMDES | MTES | TEOS | | |
| 7 | 0.20 | 0.60 | 0.20 | 6,000 | 16,000 |
| 8 | 0.34 | 0.32 | 0.34 | 6,500 | 17,000 |
| 9 | 0.42 | 0.16 | 0.42 | 6,400 | 15,000 |
| 10 | 0.47 | 0.06 | 0.47 | 8,000 | 16,700 |
| Comp. 1 | 0 | 0 | 1 | 3,000 | 6,000[*1] |
| Comp. 2 | 0 | 0.5 | 0.5 | 3,200 | 7,000[*1] |
| Comp. 3 | 0.3 | 0 | 0.7 | 5,400 | 10,000[*1] |
| Comp. 4 | 0.34 | 0.1 | 0.56 | 20,000 | 10,000[*1] |
| Comp. 5 | 0.34 | 0.56 | 0.1 | 4,900 | 10,000[*1] |
| Comp. 6 | 0.34 | 0.66 | 0 | 4,500 | 8,000[*1] |
| Comp. 7 | 0.55 | 0.45 | 0 | 5,000 | [*2] |
| Ccmp. 8 | 0.71 | 0.29 | 0 | 5,500 | [*2] |

Note *1) Cracked.
*2) Not hardened in prebaking.

Examples 11-16

In the same manner as in Example 3 but varying the composition of the oligomer of DMDES, an insulating film was formed on a wafer. Its crack resistance was evaluated. The composition of the oligomer was analyzed by gas chromatography. The results are shown in Table 3.

Table 3

| Exam-ple No. | Alkoxysilane (Molar fraction) | | | Composition of oligomer (% by mole) | | | | Molecular weight of prepolymer | Crack free max. film thickness (Å) |
|---|---|---|---|---|---|---|---|---|---|
| | DMDES | MTES | TEOS | Monomer | Dimer | Tri- to Nonamer | Others | | |
| 11 | 0.47 | 0.06 | 0.47 | 12.5 | 21.5 | 65.2 | 0.8 | 19,000 | 14,500 |
| 12 | 0.47 | 0.06 | 0.47 | 5.0 | 8.0 | 80.5 | 6.5 | 24,000 | 16,700 |
| 13 | 0.47 | 0.06 | 0.47 | 2.0 | 5.0 | 63.5 | 29.5 | 24,000 | 15,500 |
| 14 | 0.47 | 0.06 | 0.47 | 1.0 | 3.0 | 72.0 | 24.0 | 9,000 | 15,000 |
| 15 | 0.47 | 0.06 | 0.47 | 0.4 | 1.5 | 76.5 | 21.6 | 9,000 | 15,000 |
| 16 | 0.47 | 0.06 | 0.47 | 100 | --- | --- | --- | 6,000 | 14,000 |

## Claims

1. An insulating film for a semiconductor which comprises a cured product of a siloxane prepolymer, said prepolymer being a polycondensation product of

(a) a tetraalkoxysilane of the formula:

$$Si(OR^1)_4 \quad (I)$$

and (b) an alkyl- or aryl-trialkoxysilane of the formula:

$$R^2Si(OR^3)_3 \quad (II)$$

and (c) an dialkyl- or diaryl-dialkoxysilane of the formula:

$$R^4R^5Si(OR^6)_2 \quad (III)$$

in a molar fraction of (a):(b):(c) of 0.14-0.50 : 0.03-0.66 : 0.11-0.66,
wherein $R^1$ to $R^6$ are the same or different and are alkyl groups having 1 to 6 carbon atoms or aryl groups having 6 to 10 carbon atoms.

2. The insulting film according to claim 1, wherein the prepolymer contains blocks of a dialkyl- or diaryl-dialkoxysilane which is a polycondensation product of di- to deca-polycondensation oligomers of the dialkyl- or diaryl-dialkoxysilane (III) and the tetraalkoxysilane (I) and the alkyl- or aryl-trialkoxysilane (II).

3. The insulating film according to claim 1, wherein the prepolymer has a weight-average molecular weight of 2,000 to 50,000.

4. The insulating film according to claim 1, wherein $R^1$, $R^3$ and $R^6$ are the same or different and each is a $C_1$-$C_4$ alkyl group or a phenyl group.

5. The insulating film according to claim 1, wherein $R^2$, $R^4$ and $R^5$ are the same or different and each is a methyl group or a phenyl group.

6. A method for producing an insulating film on a semiconductor which comprises applying a mixture of a siloxane prepolymer in an organic solvent onto the surface of the semiconductor said prepolymer having been produced by hydrolyzing and polycondensating

(a) a tetraalkoxysilane of the formula:

$$Si(OR^1)_4 \quad (I)$$

and (b) an alkyl- or aryl-trialkoxysilane of the formula:

$$R^2Si(OR^3)_3 \quad (II)$$

and (c) an dialkyl- or diaryl-dialkoxysilane of the formula:

$$R^4R^5Si(OR^6)_2 \quad (III)$$

in a molar fraction of (a):(b):(c) of 0.14-0.50 : 0.03-0.66 : 0.11-0.66,
wherein $R^1$ to $R^6$ are the same or different and are alkyl groups having 1 to 6 carbon atoms or aryl groups having 6 to 10 carbon atoms, and thermally treating the applied mixture at temperature of 400 °C or higher in the presence of oxygen.

7. A liquid composition for forming an insulating film for a semiconductor which comprises a siloxane prepolymer said prepolymer being a polycondensation product of

(a) a tetraalkoxysilane of the formula:

$$Si(OR^1)_4 \quad (I)$$

and (b) an alkyl- or aryl-trialkoxysilane of the formula:

$R^2Si(OR^3)_3$     (II)

and (c) an dialkyl- or diaryl-dialkoxysilane of the formula:

$R^4R^5Si(OR^6)_2$     (III)

in a molar fraction of (a):(b):(c) of 0.14-0.50 : 0.03-0.66 : 0.11-0.66,
wherein $R^1$ to $R^6$ are the same or different and are alkyl groups having 1 to 6 carbon atoms or aryl groups having 6 to 10 carbon atoms and and organic solvent.

8. The liquid composition for forming an insulating film for a semiconductor according to claim 7, wherein the prepolymer contains blocks of a dialkyl- or diaryl-dialkoxysilane which is a polycondensation product of di- to deca-polycondensation oligomers of the dialkyl-or diaryl-dialkoxysilane (III) and the tetraalkoxysilane (I) and the alkyl- or aryl-trialkoxysilane (II).

9. The liquid composition for forming an insulating film for a semiconductor according to claim 7, wherein the prepolymer has a weight-average molecular weight of 2,000 to 50,000.

10. The liquid composition for forming an insulating film for a semiconductor according to claim 7, wherein the concentration of the prepolymer is at least 4 % by weight.

11. The liquid composition for forming an insulating film for a semiconductor according to claim 7, wherein the organic solvent is an alcohol, ketone, monoalkyl ether of ethylene glycol, monoalkyl ether of propylene glycol, aromatic compound or a mixture thereof.

## Revendications

1. Film isolant pour un semiconducteur, comprenant un produit cuit d'un prépolymère de siloxane, ledit prépolymère étant un polycondensat de :
   (a) un tétraalcoxysilane de formule :

   $Si(OR^1)_4$  (I)

   et (b) un alkyl- ou aryl-trialcoxysilane de formule :

   $R^2Si(OR^3)3$  (II)

   et (c) un dialkyl- ou diaryl-dialcoxysilane de formule :

   $R^4R^5Si(OR^6)_2$  (III)

   dans un rapport molaire de (a):(b):(c) de 0,14-0,50 : 0,03-0,66 : 0,11-0,66,
   $R^1$ à $R^6$ étant identiques ou différents et étant des groupements alkyles ayant 1 à 6 atomes de carbone ou des groupements aryles ayant 6 à 10 atomes de carbone.

2. Film isolant selon la revendication 1, dans lequel le prépolymère contient des blocs d'un dialkyl- ou diaryl-dialcoxysilane qui est un polycondensat de di- à déca-oligomères de poly-condensation du dialkyl- ou diaryl-dialcoxysilane (III) et du tétraalcoxysilane (I) et de l'alkyl- ou aryl-trialcoxysilane (II).

3. Film isolant selon la revendication 1, dans lequel le prépolymère a un poids moléculaire moyen en poids compris entre 2 000 et 50 000.

4. Film isolant selon la revendication 1, dans lequel $R^1$, $R^3$ et $R^6$ sont identiques ou différents et chacun de ces radicaux est un groupement alkyle en $C_1$ à $C_4$ ou un groupement phényle.

5. Film isolant selon la revendication 1, dans lequel $R^2$ $R^4$ et $R^5$ sont identiques ou différents et chacun de ces radicaux est un groupement méthyle ou un groupement phényle.

6. Procédé de production d'un film isolant sur un semi-conducteur, comprenant l'application d'un mélange d'un prépolymère de siloxane dans un solvant organique à la surface du semi-conducteur, ledit prépolymère ayant été produit par hydrolyse et polycondensation de

(a) un tétraalcoxysilane de formule :

$Si(OR^1)_4$ (I)

et (b) un alkyl- ou aryl-trialcoxysilane de formule :

$R^2Si(OR^3)_3$ (II)

et (c) un dialkyl- ou diaryl-dialcoxysilane de formule :

$R^4R^5 Si(OR^6)$ (III)

dans un rapport molaire de (a):(b):(c) de 0,14-0,50 : 0,03-0,66 : 0,11-0,66,
$R^1$ à $R^6$ étant identiques ou différents et étant des groupements alkyles ayant 1 à 6 atomes de carbone ou des groupements aryles ayant 6 à 10 atomes de carbone, et le traitement thermique du mélange appliqué à une température supérieure ou égale à 400°C en présence d'oxygène.

7. Composition liquide pour former un film isolant pour un semiconducteur, comprenant un prépolymère de siloxane, ledit prépolymère étant un polycondensat de

(a) un tétraalcoxysilane de formule :

$Si(OR^1)_4$ (I)

et (b) un alkyl- ou aryl-trialcoxysilane de formule :

$R^2 Si(OR^3)$ (II)

et (c) un dialkyl- ou diaryl-dialcoxysilane de formule :

$R^4R^5Si(OR^6)_2$ (III)

dans un rapport molaire de (a):(b):(c) de 0,14-0,50 : 0,03-0,66 : 0,11-0,66,
$R^1$ à $R^6$ étant identiques ou différents et étant des groupements alkyles ayant 1 à 6 atomes de carbone ou des groupements aryles ayant 6 à 10 atomes de carbone, et un solvant organique.

8. Composition liquide pour former un film isolant pour un semiconducteur selon la revendication 7, dans laquelle le prépolymère contient des blocs d'un dialkyl- ou diaryl-dialcoxy-silane qui est un polycondensat de di- à déca-oligomères de polycondensation du dialkyl- ou diaryl-dialcoxysilane (III) et du tétraalcoxysilane (I) et de l'alkyl- ou aryl-trialcoxysilane (II).

9. Composition liquide pour former un film isolant pour un semiconducteur selon la revendication 7, dans laquelle le prépolymère a un poids moléculaire moyen en poids compris entre 2 000 et 50 000.

10. Composition liquide pour former un film isolant pour un semiconducteur selon la revendication 7, dans laquelle la concentration du prépolymère est d'au moins 4 % en poids.

11. Composition liquide pour former un film isolant pour un semiconducteur selon la revendication 7, dans laquelle le solvant organique est un alcool, une cétone, un éther monoalkylique d'éthylèneglycol, un éther monoalkylique de propylèneglycol, un composé aromatique ou un mélange de ces substances.

**Patentansprüche**

1. Isolierende Schicht für Halbleiter, umfassend ein gehärtetes Produkt eines Siloxanpräpolymers, wobei das Präpolymer ein Polykondensationsprodukt ist aus:

(a) einem Tetraalkoxysilan der Formel:

$Si(OR^1)_4$ (I)

und

(b) einem Alkyl- oder Aryltrialkoxysilan der Formel:

$R^2si(OR^3)_3$ (II)

und

(c) einem Dialkyl- oder Diaryldialkoxysilan der Formel:

$R^4R^5Si(OR^6)_2$ (III)

in einem Molenbruchverhältnis von (a):(b):(c) von 0,14-0,50 : 0,03-0,66 : 0,11-0,66,
wobei $R^1$ bis $R^6$ gleich oder verschieden sind und Alkylreste mit 1 bis 6 Kohlenstoffatomen oder Arylreste mit 6 bis 10 Kohlenstoffatomen darstellen.

2. Isolierende Schicht nach Anspruch 1, wobei das Präpolymer Blöcke von Dialkyl- oder Diaryldialkoxysilan enthält und ein Polykondensationsprodukt von Di- bis Deca-Polykondensationsoligomeren des Dialkyl- oder Diaryldialkoxysilans (III) und des Tetraalkoxysilans (I) und des Alkyl- oder Aryltrialkoxysilans (II) ist.

3. Isolierende Schicht nach Anspruch 1, wobei das Präpolymer ein Gewichtsmittel des Molekulargewichts von 2000 bis 50 000 aufweist.

4. Isolierende Schicht nach Anspruch 1, wobei $R^1$, $R^3$ und $R^6$ gleich oder verschieden sind und jeweils einen $C_1$-$C_4$-Alkylrestoder eine Phenylgruppe darstellen.

5. Isolierende Schicht nach Anspruch 1, wobei $R^2$, $R^4$ und $R^5$ gleich oder verschieden sind und jeweils eine Methyloder Phenylgruppe darstellen.

6. Verfahren zur Herstellung einer isolierenden Schicht auf einem Halbleiter, umfassend das Aufbringen eines Gemischs eines Siloxanpräpolymers in einem organischen Lösungsmittel auf die Oberfläche des Halbleiters, wobei das Präpolymer hergestellt wurde durch Hydrolysieren und Polykondensieren von
   (a) einem Tetraalkoxysilan der Formel:

$Si(OR^1)_4$ (I)

und

(b) einem Alkyl- oder Aryltrialkoxysilan der Formel:

$R^2Si(OR^3)_3$ (II)

und

(c) einem Dialkyl- oder Diaryldialkoxysilan der Formel:

$R^4R^5Si(OR^6)_2$ (III)

in einem Molenbruchverhältnis von (a):(b):(c) von 0,14-0,50 : 0,03-0,66 : 0,11-0,66,
wobei $R^1$ bis $R^6$ gleich oder verschieden sind und Alkylreste mit 1 bis 6 Kohlenstoffatomen oder Arylreste mit 6 bis 10 Kohlenstoffatomen darstellen,
und Wärmebehandeln des aufgebrachten Gemischs bei einer Temperatur von 400° C oder höher in Gegenwart von Sauerstoff.

7. Flüssige Zusammensetzung zur Bildung einer isolierenden Schicht für Halbleiter, umfassend ein Siloxanpräpolymer und ein organisches Lösungsmittel, wobei das Präpolymer ein Polykondensationsprodukt ist aus:
   (a) einem Tetraalkoxysilan der Formel:

$Si(OR^1)_4$  (I)

und

(b) einem Alkyl- oder Aryltrialkoxysilan der Formel:

$R^2Si(OR^3)_3$  (II)

und

(c) einem Dialkyl- oder Diaryldialkoxysilan der Formel:

$R^4R^5Si(OR^6)_2$  (III)

in einem Molenbruchverhältnis von (a):(b):(c) von 0,14-0,50 : 0,03-0,66 : 0,11-0,66, wobei $R^1$ bis $R^6$ gleich oder verschieden sind und Alkylreste mit 1 bis 6 Kohlenstoffatomen oder Arylreste mit 6 bis 10 Kohlenstoffatomen darstellen.

8. Flüssige Zusammensetzung zur Bildung einer isolierenden Schicht für Halbleiter nach Anspruch 7, wobei das Präpolymer Blöcke von Dialkyl- oder Diaryldialkoxysilan enthält und ein Polykondensationsprodukt von Di- bis DecaPolykondensationsoligomeren des Dialkyl- oder Diaryldialkoxysilans (III) und des Tetraalkoxysilans (I) und des Alkyl- oder Aryltrialkoxysilans (II) ist.

9. Flüssige Zusammensetzung zur Bildung einer isolierenden Schicht für Halbleiter nach Anspruch 7, wobei das Präpolymer ein Gewichtsmittel des Molekulargewichts von 2000 bis 50 000 aufweist.

10. Flüssige Zusammensetzung zur Bildung einer isolierenden Schicht für Halbleiter nach Anspruch 7, wobei die Konzentration des Präpolymers wenigstens 4 Gew.-% beträgt.

11. Flüssige Zusammensetzung zur Bildung einer isolierenden Schicht für Halbleiter nach Anspruch 7, wobei das organische Lösungsmittel ein Alkohol, Keton, Monoalkylether von Ethylenglykol, Monoalkylether von Propylenglykol, eine aromatische Verbindung oder ein Gemisch davon ist.